# EUROPEAN PATENT SPECIFICATION

(11) **EP 2 867 391 B1**
(45) Date of publication and mention of the grant of the patent: **18.05.2016**
(21) Application number: 13745724.8
(22) Date of filing: 31.05.2013
(51) Int. Cl.: C30B 23/02, C30B 25/18, C30B 29/06, H01L 21/02

(54) **METHOD FOR FABRICATING SILICENE LAYERS UPON A SUBSTRATE OF CRYSTALLINE BETA-SILICON NITRIDE**
VERFAHREN ZUR HERSTELLUNG VON SILICENE SCHICHTEN AUF EINEM SUBSTRAT AUS KRISTALLINEM BETA- SILICIUMNITRID
PROCÉDÉ DE FABRICATION DE COUCHES DE SILICÈNE SUR UN SUBSTRAT CRISTALLIN DE BETA-NITRURE DE SILICIUM

(30) Priority: 28.06.2012 IT RM20120305
(43) Date of publication of application: 06.05.2015
(73) Proprietor: Consiglio Nazionale Delle Ricerche, 00185 Roma (IT)
(72) Inventor: FLAMMINI, Roberto, I-00185 Roma (IT); TRUCCHI, Daniele Maria, I-00185 Roma (IT)
(74) Representative: Scilletta, Andrea
(86) International application number: PCT/IT2013/000154
(87) International publication number: WO 2014/002123

(56) References cited:
- ABDELKADER KARA ET AL: "A review on silicene New candidate for electronics", SURFACE SCIENCE REPORTS, ELSEVIER SCIENCE, NL, vol. 67, no. 1, 10 October 2011 (2011-10-10), pages 1-18, XP028113774, ISSN: 0167-5729, DOI: 10.1016/J.SURFREP.2011.10.001 [retrieved on 2011-10-14]
- MING YANG ET AL: "Graphene on [beta]-Si3N4: An ideal system for graphene-based electronics", AIP ADVANCES AMERICAN INSTITUTE OF PHYSICS USA, vol. 1, no. 3, 1 September 2011 (2011-09-01), pages 032111-1-032111-6, XP002691288, DOI: 10.1063/1.3623567 cited in the application

## Description

The present invention relates to a method for fabricating a structure comprising a monatomic layer of crystalline silicon upon an electrically insulating layer of crystalline silicon nitride in the β structural form. The method has the advantage to be efficiently, reliably and quickly integrated in the present semiconductor industry. Manufacturing of a monatomic layer of crystalline silicon is aimed at fabricating semiconductor devices having high electronic mobility.

In the last years there has been a growing interest in the research sector to obtain electronic devices having a high electronic mobility, i.e. characterized by high velocity of charge carriers. Starting from the development of a simple method for manufacturing a single layer ("monolayer") of graphite, also known as graphene, as demonstrated by Novoselov e Geim et al. in "Electric Field Effect in Atomic Thin Carbon Films" Science 306 (2004) 666 (see also Nature 438 (2005) 197, and Nature Mat. 6 (2007) 183, a large number of new electronic, magnetic and mechanical properties due to the two-dimensionality of graphene system has drawn attention of technicians and researchers.

Particularly, it is foreseen that graphene can replace silicon in semiconductor microelectronics devices thanks to its "ultra high" electronic mobility (up to 2x10⁵ cm² V⁻¹ s⁻¹), thanks to its unusual topology of electronic bands due to two-dimensional confinement and characterized by the presence of the so-called Dirac cones.

However, semiconductor industry is not at present able to manufacture microelectronic devices based on graphene without facing relevant modifications of the manufacturing processes and of the relevant plants, mainly due to the use of expensive silicon carbide (SiC) crystalline substrates, necessary to grow graphene on insulating substrates. Said modifications of the manufacturing processes and of the relevant plants would involve remarkable costs.

A monatomic layer of crystalline silicon, particularly silicene, with coordination of silicon atoms similar to graphite sp² (or sp²-like) can reproduce electronic properties of graphene, and could represent a material widely more compatible with the present technology and satisfying the needs of microelectronic industry.

More recently, in Vogt et al. Phys. Rev. Lett. 108 (2012) 155501, it has been demonstrated for the first time that it is possible to grow a monatomic layer of crystalline silicon in the silicene form. In fact, it has been made a silicon structure based on hybridization similar to the one of sp² and with a "buckled" honeycomb structure, necessary to exploit its electronic properties. Reasons for the buckling of the monatomic layer of crystalline silicon in the silicene form, with respect to the perfectly flat form of graphene, is due to the fact that the bond between two Si atoms is longer than the bond between two C atoms (in hexagonal structure) and the overlapping of p_{z} orbitals (orthogonal to the plane) is negligible. The above permits to p_{z} orbitals to rotate and overlap to the s orbitals, thus realizing a hybridization similar to the one of sp³. The equivalent of carbon aromatic ring, formed by Si atoms, is thus spontaneously subjected to an out-of-plane distortion inducing a buckled two-dimensional arrangement, instead of a planar (monatomic) two-dimensional layer. For this reason, it is said that silicon atoms are partially sp² and partially sp³ hybridized. On this point, scientific community agrees on calculations concerning the instability of two-dimensional planar structure, as described in S. Cahangirov et al., Phys. Rev. Lett. 102 (2009) 236804, and Liu et al., Phys. Rev. Lett. 107 (2011) 076802. The above is not necessarily a drawback, since, while a perfectly planar two-dimensional structure is semi-metallic, calculations demonstrate that a buckled structure has a forbidden region, also known as band gap, at point K of Brillouin zone, and thus linked to semi conductive properties. In Vogt et al. estimated energy of band gap is 0.6 eV, the case of crystalline silicon monatomic layer in silicene/Ag (111) form.

However, as stated in the case of graphene by M. Yang et al. in AIP Advancesl (2011) 032111, ultra-high electronic mobility can be remarkably reduced with respect to a suspended (free-standing) two-dimensional layer, due to interaction with a metallic substrate. Only dielectric substrates with a high relative dielectric constant (i.e. high k) can permit to preserve graphene electronic mobility properties.

The above even more applies to the monatomic layer of crystalline silicon in silicene form, due to the reactivity of silicon. Under a technological point of view, as emphasized by G. Le Lay et al. in Appl. Surf. Sci. 256 (1009) 524, by Lalmi et al in Appl. Phys. Lett. 97 (2010) 223109, by De Padova et al. in Appl. Phys. Lett. 96 (2010) 183102, in order to use monatomic layer of crystalline silicon in silicene form for electronic devices, same silicene should be detached from the metallic substrate, deposited on an electrically insulating support and suitably protected by a coating layer.

Other disclosures of the prior art, limited to the growth of dielectric substrate with high k, have been published by Flammini et al. in "Thermal behavior of Au/c-Si3N4/Si (111) interface", Journal of Applied Physics 103 (2008) 083528 and in "Crystalline silicon nitride passivating the Si (111) surface: A study of the Au growth mode", in Surface Science 579 (2005) 188, and also in "Thermal stability of the Co/β-Si3N4/Si (111) interface: A photoemission study" Surface Science 606 (2012) 1215, wherein a method is taught to grow a ultra-thin crystalline layer of silicon nitride on a Si(111) substrate. The above publications describe the behavior of Au/β-Si₃N₄/Si (111) interface and of Co/β-Si₃N₄/Si (111) interface as a function of temperature. Metals (Au and Co) have been grown in an amorphous phase on silicon nitride surface at room temperature. Amorphous structure of metallic layers is due to a complex series of energetic reasons, but it is also due to a not perfect matching between the lattice of the silicon nitride and the one of the concerned metals. Interface has been then heated by passage of electric current, so as to be able to study the behavior as a function of the temperature.

Therefore, it is object of the present invention that of permitting, in an efficient and reliable way, to fabricate periodic monatomic structures, i.e. with a crystalline structure showing properties like ultra-high electronic mobility, by methods that can be implemented in systems already existing in the present semiconductor industry with a material, particularly silicon, representing the standard.

It is therefore specific object of the present invention a method for fabricating a structure comprising a silicone layer upon an electrically insulating layer of crystalline silicon nitride in the β structural form, comprising the following steps: as described in claim 1.

Always according to the invention, step D is performed by increasing the temperature of the whole structure, such temperature being not higher than 350°C.

Still according to the invention, said step B can comprise in the order:
B.1 outgassing Si (111) substrate in Ultra High Vacuum (UHV) for at least 10' under a vacuum pressure of at least 1x10 ⁻⁹mbar
B.2 subjecting the whole structure to at least one flash heating up to a temperature ranging from 850°C to 1150°C, preferably ranging from 900°C to 1100°C, more preferably ranging from 950°C to 1050°C, still more preferably ranging from 980°C to 1020°C, for at least 10 s; preferably by an electric current heating, obtaining a clean surface of the Si (111) substrate at an atomic level.

Particularly, before said step B1, it can be carried out the step B.0, comprising

B.0. treating the crystalline silicon monatomic layer with a hydrofluoric acid (HF) and nitric acid (HNO₃) aqueous solution to remove the native oxide to protect the clean face with clean oxide.

Furthermore, according to the invention, said at least one face of said Si (111) substrate worked in said step C shows a 7x7 reconstruction.

Still according to the invention, said step C can comprise a further step:
C". keeping the whole structure at a temperature between 700°C and 800°C, preferably between 720°C and 780°C, more preferably between 740°C and 760°C and at the same time exposed to values comprised between 10 L and 250 L (1 Langmuir is equivalent to 10⁻⁶ Torr s), preferably between 50 L and 200 L, more preferably between 90 L and 150 L of ammonia (NH₃), obtaining an 8x8 reconstruction of the upper face of the crystalline silicon nitride layer in the β structural form grown on said face.

Still according to the invention, said method can comprise a further step:
E. thermal growing of a further monatomic layer of crystalline silicon produced during said step D, said step E being carried out more times.

Furthermore, according to the invention, said method can comprise a further step:
E'. overlapping a crystalline silicon nitride layer in the β structural form and a monatomic layer of crystalline silicon upon said crystalline silicon monatomic layer previously produced during said step D, said step E' being eventually carried out more times.

Furthermore, according to the invention, each one of said steps C., D., E., E'. can be, alone or in combination with the others, carried out upon both faces of said Si(111) substrate.

Method according to the invention permits to fabricate structures with a monatomic layer of silicene, and insulating, where silicene is grown *in situ,* under Ultra High Vacuum (UHV) conditions, directly on the top of an electrically insulating layer of silicon nitride (β-Si₃N₄). Said silicon nitride (β-Si₃N₄) layer has the remarkable capability to grow epitaxially on a Si face with crystallographic orientation (111) (i.e. Si(111)), thanks to a negligible lattice mismatch, lower than 1.2%, between the unitary cell of (β-Si₃N₄) (0001) face and the 2x2 cell of Si(111).

Advantages connected with method of deposition of silicene *in situ* on an electrically insulating layer within the same vacuum chamber, without the need to extract the same therefrom, are repeatability of physical properties of grown material, reduction of effect of possible contaminating substances and possibility of automatizing the method. Said advantages permit to fabricate microelectronic semiconductor devices with ultra-high electronic mobility by a technology that can be immediately implemented in systems already available in the semiconductor industry for electronic and opto-electronic applications.

The present invention will be now described, for illustrative, but not limitative, purposes, making reference to its preferred embodiments, with specific reference to the figures of the enclosed drawings, wherein:
figure 1 is a schematic view of a first embodiment;
figure 2 is a schematic view of embodiment of figure 1 with an additional step;
figure 3 is a schematic view of a second embodiment; and
figure 4 is a schematic view of a third embodiment.

One of main technical problems of scientific community of surface physics, presently working on low dimensional silicon (or carbon) structures, is the capability to prepare a hybridized monatomic layer sp²/sp³ on an electrically insulating support. The inventors have solved said problem by growing silicon atoms by molecular beam epitaxy or MBE on the β-Si₃N₄(0001)/Si(111) structure. The structure thus obtained can be indicated as silicene/β-Si₃N₄(0001)/Si(111) structure.

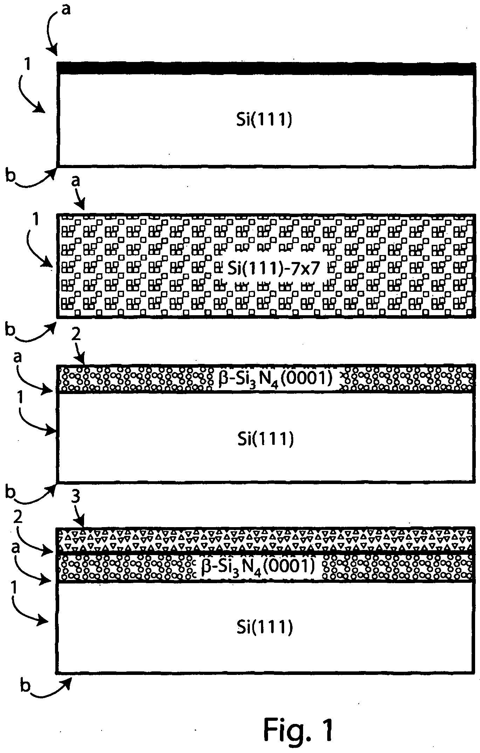

The method, also making reference to the enclosed figures, particularly to figure 1, comprises the following steps:
A. providing a standalone Si (111) substrate 1, 21, 31;
B. thermally treating the substrate 1, 21, 31 so that the Si (111) surface is clean, i.e. non contaminated at an atomic level;
C. thermally growing a crystalline silicon nitride layer 2, 22, 32 in the β structural form on at least one face a, a', a" or b, b', b" of said Si (111) substrate 1, 21, 31;
D. thermally growing a crystalline silicon monatomic layer 3, 23, 33 on the crystalline silicon nitride layer 2, 22, 32.

Step B is preferably carried out as follows. Once Si(111) substrate 1, 21, 31 has been outgassed in UHV (Ultra High Vacuum) for a variable time period of at least 10', not longer than 12 hours, at a vacuum pressure of at least 1x10⁻⁹ mbar, preferably between 2x10⁻¹⁰ and 4x10⁻¹⁰ mbar, more preferably between 2.5x10⁻¹⁰ and 3.5x10⁻¹⁰ mbar, substrate 1, 21, 31 is subjected to at least one flash heating up to a temperature ranging from 850°C to 1150°C, preferably ranging from 900°C to 1100°C, more preferably ranging from 950°C to 1050°C, still more preferably ranging from 980°C to 1020°C, for at least 10 s; preferably by a heating obtained by electric current passage, or by electronic bombardment or by thermal contact. Control of cleaning of surface at atomic level of substrate surface 1, 21, 31 of Si(111) is preferably operated by checking of 7x7 reconstruction.

Preferably, before step B a step B.0. during which the silicene layer is subjected to treatment based on a hydrofluoric acid (HF) and nitric acid (HNO₃) aqueous solution (known as "Shiraki procedure") to remove the native oxide to protect the clean face with clean oxide.

Step C is preferably carried out as follows. Clean surface a, a', a" or b, b', b" of Si(111) substrate 1, 21, 31 is maintained at a temperature between 700°C and 800°C, preferably between 720°C and 780°C, more preferably between 740°C and 760°C and at the same time exposed to values ranging from 10 to 250 L (1 L is equal to 10⁻⁶ Torr s), preferably from 50 to 200 L, more preferably from 90 to 150 L of ammonia (NH₃). The above gives an 8x8 reconstruction of the upper face of crystalline silicon nitride layer 2, 22, 32 in the β structural form. It is also possible to prepare the silicon nitride surface 2, 22, 32 through the plasma nitridation technique, in presence of N₂, as taught in the following prior art: Hong Mao Lee et al. Appl. Phys. Lett. 95 (2009) 222104.

Particularly, steps A, B and C are preferably carried out according to the teachings of the above mentioned publications by R. Flammini et al.

Step D of the growth of crystalline silicene layer occurs at a temperature preferably between 100°C and 280°C, never above 350°C nor under 100°C, more preferably between 250°C and 280°C, as follows. Once the crystalline silicon nitride layer 2, 22, 32 in β structural form has been grown on the face a, a', a" or b, b', b" of the substrate 1, 21, 31 Si(111), pressure must be recovered up to at least 1x10⁻⁹ mbar. Then, growth of silicon 3, 23, 33 is made on top of silicon nitride layer 2, 22, 32 by MBE (Molecular Beam Epitaxy). Particularly, inventors have observed that so grown silicon has characteristics similar to those of graphene, i.e. low dimensionality characteristics, for two reasons: the first one is capability of nitride surface of being inert up to 300°C, not even reacting with very reactive metals, such as gold or cobalt; the second reason is the very low lattice mismatch, lower than 1.2%, between the β-Si₃N₄(000.1) face and the 2x2 cell of Si(111), and consequently very close to the lattice constant of silicene (Liu et al. Phys. Rev. Lett. Vol.107 (2011) 076802).

The Applicant has observed that, when silicene has been deposited, silicon atoms place themselves according to a hybridized structure sp²/sp³, ensuring the ultra-high electronic mobility property. Particularly, diffusion of silicon atoms during growth of silicon in silicene form is advantageously promoted by a moderate temperature increase of the β-Si₃N₄/Si(111) structure, preferably between 100°C and 280°C, never above 350°C nor under 100°C, more preferably between 250°C and 280°C. Beyond 350°C temperature, silicon nitride layer would be subjected to surface cracking or breaking that would deteriorate the integrity and consequently the usability of the whole monolayer structure of silicon/β-Si₃N₄/Si(111).

A method for fabricating a monolayer structure has been described above, wherein a growth of silicon in the silicene form 3, 23, 33 on a silicon nitride layer 2, 22, 32 occurs.

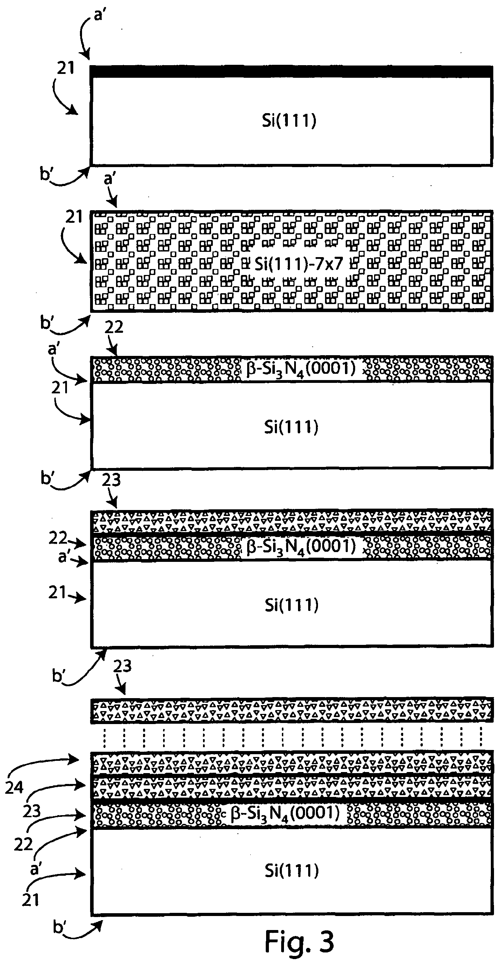

A second embodiment, as shown in figure 3, is given by the fabrication of a multilayer structure, still using the same method. Said structure presents the growth of one or more consecutive silicon layers 23, 24 in the form of silicene on the silicon nitride layer 22.

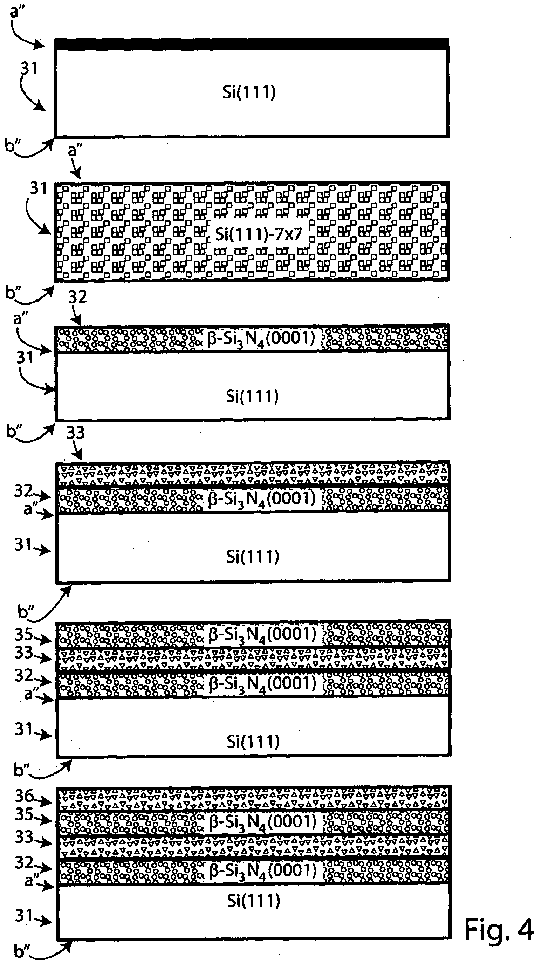

A third embodiment, as shown in figure 4, is given by the fabrication of a multilayer structure, wherein consecutive alternations of silicon nitride layer 32, 35 and silicene 33, 36 are present.

A fourth claimed embodiment is given by the possibility to have one or more layers, as described hereinbefore, on both faces a, a', a" or b, b', b" of the substrate 1, 21, 31.

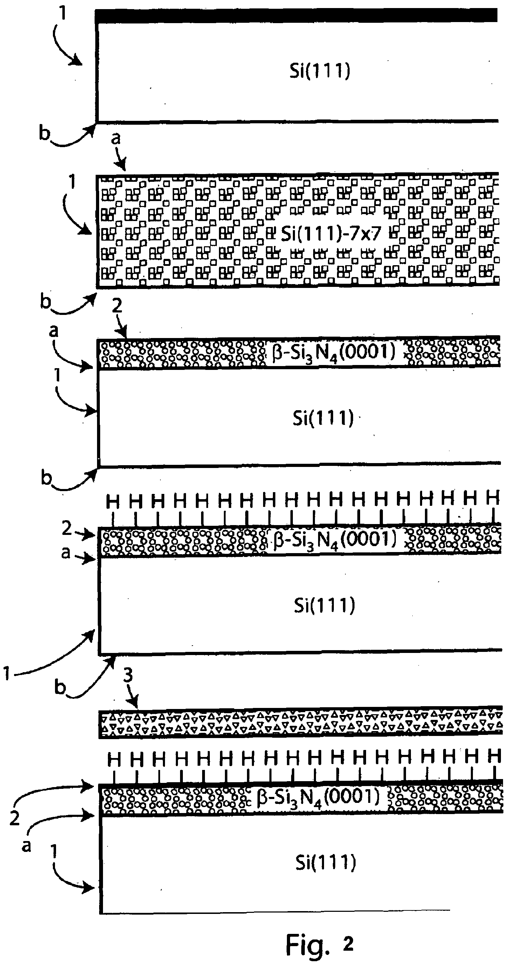

A fifth embodiment, as shown in figure 2, is given by the passivation step of the surface 2, 22, 32 of silicon nitride by hydrogenation.

The hydrogenation step can be carried out before deposition of silicon: a hot filament is first maintained at a temperature ranging from 1200°C to 2100°C, preferably from 1600°C to 2000°C, more preferably from 1700°C to 1900°C, at a distance ranging from 0.5 cm to 3.5 cm, preferably from 1 cm to 2.5 cm, more preferably from 1.5 cm to 2.2 cm, from the silicon substrate, the latter being maintained at a temperature ranging from 100°C to 200°C, preferably from 120°C to 180°C, more preferably from 140°C to 170°C, in a molecular hydrogen (H₂) atmosphere, at 10⁻⁵ mbar for a time period ranging from 1' to 40', or preferably from 10' to 30', more preferably from 12' to 18'. After this method, it is necessary to wait for the substrate temperature to return to room temperature, and for the pressure to recover to at least to 1x10⁻⁹ mbar.

The preferred embodiments of this invention have been described and a number of variations have been suggested hereinbefore, but it should be understood that those skilled in the art can make variations and changes, without so departing from the scope of protection thereof, as defined by the attached claims.

## Claims

1. Method for fabricating a structure comprising a silicene layer upon an electrically insulating layer of crystalline silicon nitride in the β structural form, comprising the following steps:
A. providing a standalone Si (111) substrate (1, 21, 31), said substrate (1, 21, 31) comprising a first face (a, a', a") and a second main face (b, b', b");
B. thermally treating the substrate (1, 21, 31) so that the Si (111) surface is clean, i.e. non contaminated at an atomic level;
C. thermally growing a crystalline silicon nitride layer (2, 22, 32) in the β structural form on at least one face (a, a', a"; b, b', b") of said Si (111) substrate (1, 21, 31);
D. thermally growing a silicene layer (3, 23, 33) on the crystalline silicon nitride layer (2, 22, 32) by Molecular Beam Epitaxy (MBE) under a pressure of at least 1x10⁻⁹ mbar and at a temperature between 100°C and 350°C.

2. Method according claim 1, wherein step D occurs at a temperature between 100° and 280°.

3. Method according claim 1, wherein step D occurs at a temperature between 250° and 280°.

4. Method according to any one of the preceding claims, comprising a further step:
C'. passivation of dangling bonds of the crystalline silicon nitride layer (2, 22, 32) by hydrogen or by halogens.

5. Method according to any one of the preceding claims, **characterized in that** step B comprises in the order:
B.1 outgassing Si (111) substrate (1, 21, 31) in Ultra High Vacuum (UHV) for at least 10' under a vacuum pressure of at least 1x10⁻⁹ mbar
B.2 subjecting the whole structure to at least one flash heating up to a temperature ranging from 850°C to 1150°C, preferably between 900°C and 1100°C, more preferably between 950°C and 1050°C, more preferably between 980°C and 1020°C, for at least 10 s, preferably by an electric current heating obtaining a clean surface of the Si (111) substrate (1, 21, 31) at an atomic level.

6. Method according to any one of the preceding claims, **characterized in that** said at least one face (a, a', a"; b, b', b") of said Si (111) substrate worked in said step C has a 7x7 reconstruction.

7. Method according to any of claims 1 to 5, **characterized in that** said step C comprises a further step:
C". keeping the whole structure at a temperature between 700°C and 800°C, preferably between 720°C and 780°C, more preferably between 740°C and 760°C and at the same time exposed to values comprised between 10 L and 250 L (1 Langmuir is equivalent to 10⁻⁶ Torr s), preferably between 50L and 200 L, more preferably between 90 L and 150 L of ammonia (NH₃), obtaining an 8x8 reconstruction of the upper face of the crystalline silicon nitride layer (2, 22, 32) in the β structural form grown on said face (a, a', a"; b, b', b").

8. Method according to any of previous claims, comprising a further step:
E. thermal growing of a further silicene layer (24) produced during said step D.

9. Method according to claim 8, **characterized in that** said step E is carried out more times.

10. Method according to any of claims 1 to 7, comprising a further step:
E'. overlapping a crystalline silicon nitride layer (35) in the β structural form and a silicene layer (36) upon said silicene layer (33) previously produced during said step D.

11. Method according to claim 10 **characterized in that** said step E' is carried out more times.

12. Method according to any of previous claims, **characterized in that** each one of said steps C., D., E., E'. can be, alone or in combination with the others, carried out upon both faces (a"; b") of said Si(111) substrate.

## Patentansprüche

1. Verfahren zur Herstellung einer Struktur, die eine Silicenschicht auf einer elektrisch isolierenden Schicht aus kristallinem Siliziumnitrid in der β-Struktur umfasst, wobei das Verfahren die folgenden Schritte umfasst:
A. Bereitstellen eines freistehenden Si (111)-Substrats (1, 21, 31), wobei das Substrat (1, 21, 31) eine erste Seite (a, a', a") und eine zweite Hauptseite (b, b', b") umfasst;
B. thermisches Behandeln des Substrats (1, 21, 31), sodass die Si (111)-Fläche sauber ist, das heißt auf Atomebene nicht verunreinigt ist;
C. thermisches Aufwachsen einer kristallinen Siliziumnitridschicht (2, 22, 32) in der β-Struktur auf mindestens einer Seite (a, a', a"; b, b', b") des genannten Si (111)-Substrats (1, 21, 31);
D. thermisches Aufwachsen einer Silicenschicht (3, 23, 33) auf der kristallinen Siliziumnitridschicht (2, 22, 32) durch Molekularstrahlepitaxie (Molecular Beam Epitaxy, MBE) bei einem Druck von mindestens 1x10⁻⁹ mbar und bei einer Temperatur zwischen 100°C und 350°C.

2. Verfahren nach Anspruch 1, bei dem Schritt D bei einer Temperatur zwischen 100° und 280° erfolgt.

3. Verfahren nach Anspruch 1, bei dem Schritt D bei einer Temperatur zwischen 250° und 280° erfolgt.

4. Verfahren nach einem der vorhergehenden Ansprüche, das weiterhin den folgenden Schritt umfasst:
C'. Passivieren von offenen Bindungen der kristallinen Siliziumnitridschicht (2, 22, 32) durch Wasserstoff oder durch Halogene.

5. Verfahren nach einem der vorhergehenden Ansprüche, **dadurch gekennzeichnet, dass** Schritt B Folgendes in der folgenden Reihenfolge umfasst:
B.1 Ausgasen des Si (111)-Substrats (1, 21, 31) in Ultrahochvakuum (UHV) für mindestens 10' bei einem Vakuumdruck von mindestens 1x10⁻⁹ mbar,
B.2 Aussetzen der gesamten Struktur mindestens einem schnellen Aufheizen auf eine Temperatur im Bereich von 850°C bis 1150°C, vorzugsweise zwischen 900°C und 1100°C, besonders vorzugsweise zwischen 950°C und 1050°C, insbesondere zwischen 980°C und 1020°C, für mindestens 10 s, vorzugsweise durch ein Heizen mittels elektrischem Strom, sodass eine saubere Oberfläche des Si (111)-Substrats (1, 21, 31) auf Atomebene erhalten wird.

6. Verfahren nach einem der vorhergehenden Ansprüche, **dadurch gekennzeichnet, dass** die genannte mindestens eine Seite (a, a', a"; b, b', b") des genannten Si (111)-Substrats, die im genannten Schritt C bearbeitet wurde, eine 7x7-Rekonstruktion hat.

7. Verfahren nach einem der Ansprüche 1 bis 5, **dadurch gekennzeichnet, dass** der genannte Schritt C den folgenden weiteren Schritt umfasst:
C". Halten der gesamten Struktur auf einer Temperatur zwischen 700°C und 800°C, vorzugsweise zwischen 720°C und 780°C, besonders vorzugsweise zwischen 740°C und 760°C, wobei die gesamte Struktur gleichzeitig Werten zwischen 10 L und 250 L (1 Langmuir entspricht 10⁻⁶ Torr s), vorzugsweise zwischen 50 L und 200 L, besonders vorzugsweise zwischen 90 L und 150 L von Ammonium (NH₃) ausgesetzt ist, sodass eine 8x8-Rekonstruktion der oberen Seite der kristallinen Siliziumnitridschicht (2, 22, 32) in der β-Struktur aufgewachsen auf der genannten Seite (a, a', a"; b, b', b") erhalten wird.

8. Verfahren nach einem der vorhergehenden Ansprüche, das weiterhin den folgenden Schritt umfasst:
E. thermisches Aufwachsen einer weiteren Silicenschicht (24), welche während des genannten Schritts D erzeugt wird.

9. Verfahren nach Anspruch 8, **dadurch gekennzeichnet, dass** Schritt E mehrmalig ausgeführt wird.

10. Verfahren nach einem der Ansprüche 1 bis 7, das den folgenden weiteren Schritt umfasst:
E'. Überlagern einer kristallinen Siliziumnitridschicht (35) in der β-Struktur und einer Silicenschicht (36) auf der genannten Silicenschicht (33), welche zuvor während des genannten Schritts D erzeugt wurde.

11. Verfahren nach Anspruch 10, **dadurch gekennzeichnet, dass** Schritt E' mehrmalig ausgeführt wird.

12. Verfahren nach einem der vorhergehenden Ansprüche, **dadurch gekennzeichnet, dass** jeder der genannten Schritte C., D., E., E'. allein oder in Kombination mit den anderen auf beiden Seiten (a"; b") des genannten Si (111)-Substrats ausgeführt werden kann.

## Revendications

1. Procédé de fabrication d'une structure comprenant une couche de silicène sur une couche électriquement isolante de nitrure de silicium cristallin sous la forme structurelle β, comprenant les étapes suivantes consistant à :
A. utiliser un substrat (1, 21, 31) de Si (111) autonome, ledit substrat (1, 21, 31) comprenant une première face (a, a', a") et une seconde face principale (b, b', b") ;
B. traiter thermiquement le substrat (1, 21, 31) de sorte que la surface de Si (111) soit propre, c'est-à-dire non contaminée au niveau atomique ;
C. faire croître thermiquement une couche de nitrure de silicium cristallin (2, 22, 32) sous la forme structurelle β sur au moins une face (a, a', a" ; b, b', b") dudit substrat (1, 21, 31) de Si (111) ;
D. faire croître thermiquement une couche de silicène (3, 23, 33) sur la couche de nitrure de silicium cristallin (2, 22, 32) par épitaxie par jets moléculaires (MBE : Molecular Beam Epitaxy) sous une pression d'au moins 1x10⁻⁹ mbar et à une température comprise entre 100 °C et 350 °C.

2. Procédé selon la revendication 1, dans lequel l'étape D se produit à une température comprise entre 100 °C et 280 °C.

3. Procédé selon la revendication 1, dans lequel l'étape D se produit à une température comprise entre 250 °C et 280 °C.

4. Procédé selon l'une quelconque des revendications précédentes, comprenant une étape supplémentaire consistant à :
C'. passiver des liaisons pendantes de la couche de nitrure de silicium cristallin (2, 22, 32) par de l'hydrogène ou par des halogènes.

5. Procédé selon l'une quelconque des revendications précédentes, **caractérisé en ce que** l'étape B consiste, dans l'ordre, à :
B.1 dégazer le substrat (1, 21, 31) de Si (111) sous ultravide (UHV) pendant au moins 10' sous une pression sous vide d'au moins 1x10⁻⁹ mbar ;
B.2 soumettre toute la structure à au moins un chauffage éclair jusqu'à une température comprise dans la plage allant de 850 °C à 1150 °C, de préférence entre 900 °C et 1100 °C, plus préférablement entre 950 °C et 1050 °C, plus préférablement entre 980 °C et 1020 °C, pendant au moins 10 s, de préférence par un chauffage par courant électrique donnant une surface propre du substrat (1, 21, 31) de Si (111) au niveau atomique.

6. Procédé selon l'une quelconque des revendications précédentes, **caractérisé en ce que** ladite au moins une face (a, a', a" ; b, b', b") dudit substrat (1, 21, 31) de Si (111) travaillée dans ladite étape C a une reconstruction 7x7.

7. Procédé selon l'une quelconque des revendications 1 à 5, **caractérisé en ce que** ladite étape C comprend une étape supplémentaire consistant à :
C". conserver toute la structure à une température comprise entre 700 °C et 800 °C, de préférence entre 720 °C et 780 °C, plus préférablement entre 740 °C et 760 °C et en même temps exposée à des valeurs comprises entre 10 L et 250 L (1 Langmuir est équivalent à 10⁻⁶ Torr s), de préférence entre 50 L et 200 L, plus préférablement entre 90 L et 150 L d'ammoniac (NH₃), donnant une reconstruction 8x8 de la face supérieure de la couche de nitrure de silicium cristallin (2, 22, 32) sous la forme structurelle β cultivée sur ladite face (a, a', a" ; b, b', b").

8. Procédé selon l'une quelconque des revendications précédentes, comprenant une étape supplémentaire consistant à :
E. faire croître thermiquement une couche de silicène (24) supplémentaire produite pendant ladite étape D.

9. Procédé selon la revendication 8, **caractérisé en ce que** ladite étape E est réalisée plusieurs fois.

10. Procédé selon l'une quelconque des revendications 1 à 7, comprenant une étape supplémentaire consistant à :
E'. faire chevaucher une couche de nitrure de silicium cristallin (35) sous la forme structurelle β et une couche de silicène (36) sur ladite couche de silicène (33) précédemment produite pendant ladite étape D.

11. Procédé selon la revendication 10, **caractérisé en ce que** ladite étape E' est réalisée plusieurs fois.

12. Procédé selon l'une quelconque des revendications précédentes, **caractérisé en ce que** chacune desdites étapes C, D, E, E' peut être, seule ou en combinaisons avec d'autres, réalisée sur les deux faces (a" ; b") dudit substrat de Si (111).
